(19)

Europäisches
Patentamt
European
Patent Office
Office européen
des brevets

(11) **EP 2 458 696 A1**

(12) **EUROPEAN PATENT APPLICATION**

(43) Date of publication:
30.05.2012 Bulletin 2012/22

(51) Int Cl.:
*H01S 5/065* (2006.01)    *H01S 5/0625* (2006.01)
*H01S 5/34* (2006.01)

(21) Application number: 10306311.1

(22) Date of filing: 29.11.2010

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Alcatel Lucent
75007 Paris (FR)

(72) Inventors:
• Shen, Alexandre
91767, PALAISEAU (FR)
• MAKE, Dalila
91767, PALAISEAU (FR)

(74) Representative: Shamsaei Far, Hassan
Alcatel-Lucent International
32, avenue Kléber
92700 Colombes (FR)

(54) **A frequency tunable mode locked laser diode and a method of tuning frequency in a mode locked laser diode**

(57) A tunable mode locked laser diode wherein a first section (11) is made of an active material and is configured to provide gain for laser emission by the diode. A second section (13) made of a strained passive material is used in the laser diode structure in order to tune the frequency of said laser emission in response to a bias current injected to the second section. A method for tuning frequency in a mode locked laser diode is also disclosed.

FIG_2

**Description**

The present invention relates to optical components and in particular to tunable mode locked laser diodes.

BACKGROUND ART

Mode locked laser diodes (MLLD) are laser sources which are capable of producing optical signals at very high frequencies which are inversely proportional to the optical cavity length of the lasers. In the context of the present description frequencies typically ranging from 10GHz to more than 300GHz are considered as high frequencies which typically correspond to $4283\mu m$ and $143\mu m$ long InP-based MLLDs. Such MLLDs are currently developed in certain laboratories. Some examples of applications of such MLLDs may be in radio on fiber for mobile and fixed network convergence, optical pulse generation for OTDM (Optical Time Domain Multiplexing) for high bit-rate transmission, optical clock recovery, optical carrier frequency comb generation or optical label code generation for classical or burst mode packet switching.

SUMMARY

One important obstacle for an industrial production of such laser sources is a typically poor control on the free spectral range (FSR) of these devices, which is an important parameter to precisely reach customer required frequencies. Free spectral range (FSR) is typically known as a distance measured in terms of frequency (or wavelength) between two successive and corresponding intensity points on the intensity versus frequency (or wavelength) curve of an optical signal, for example the distance between two successive and corresponding maxima points. Such a curve is typically called an optical spectrum of the laser emission.

In one known practice, the value of the FSR is typically determined by the optical length of the laser cavity of the laser diode, which is typically controlled by the cleaving of a Fabry-Perot (FP) laser diode. The following formula represents the relationship between the cavity length L of the laser device to the value of the FSR in terms of cavity basic frequency f0:

$$FSR = f0 = c / (2\, n_g\, L),$$

where c is the velocity of light in vacuum, and $n_g$ is the effective group index of the laser waveguide. The cleaving precision is typically about $5\mu m$ using currently available tools such as binocular microscopes and the knowledge of a person skilled in the art. Using the formula above, one can represent the relationship between the cleaving precision DL and the FSR precision Df0 as follows:

$$Df0 = c\, DL / (2\, n\, L^2).$$

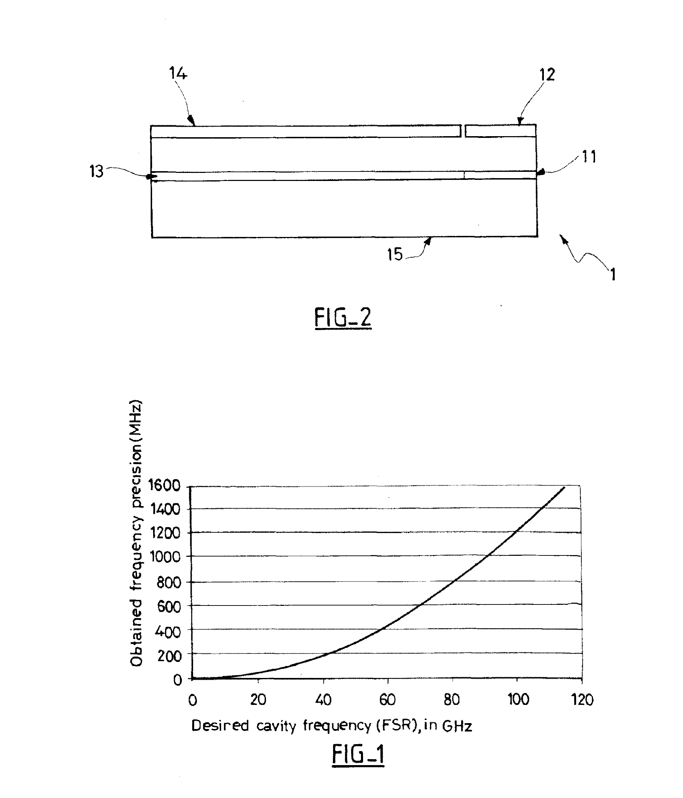

An exemplary curve based on the above relationship is shown in figure 1. In the graph shown in this figure, the X-axis represents the desired cavity frequency and Y-axis represents a frequency precision obtainable according to known techniques. For example it may be assumed that a customer requirement on frequency precision at 42.66GHz repetition rate is +/-40MHz. However, the cleaving precision is typically about or even more than 200MHz which is over the frequency precision required by the customer and therefore causes significant drawbacks in achieving the requirements established by the customer. Faced with this problem, it is desired to find an economic solution which enables to tune the actual frequency of the laser within the range required by the customer. In order to obtain this objective, one known method currently in use is to cleave many barrettes and test them all. Briefly, a barrette, as known in the related art, is a set of laser chips which have the same cavity length and is typically obtained from cleaving a processed wafer. In practice, the length of the lasers are typically chosen according to the specific need and based on such length selection the dimension of the barrette is determined. However once the barrette is cleaved, the real cavity length of the lasers on the barrette may differ from the desired length by +/- $5\mu m$. Therefore, if the real laser cavity length is not exactly the desired length, which may often be the case, then many chips on that specific barrette cannot be used because they cannot fulfill the requirements established by the customer. On the other hand, if the tested frequency of the cleaved barrettes falls within the customer range, then some of the chips on the barrette can be used to be shipped to the customer, while others are simply lost. However, the above solution is time consuming and costly, which may be one reason for impeding the industrial development of the MLLD so far. Embodiments of the invention feature a frequency tunable mode locked laser diode comprising a first section made of an active material having a first refractive index and configured to provide gain for a laser emission of said diode and a second section made of a strained passive material having a second refractive index, said laser diode being configured to generate a laser beam by means of propagation of light-waves through said second section and said first section, said light-waves having a respective phase, wherein said second refractive index of the second section is changeable in response to a current injected to said second section such that a change in said refractive index causes a change in the phase of said light-waves, thereby varying the free spectral range of the laser beam.

According to some specific embodiments, said change in said refractive index causes a change in an optical length of a laser cavity comprising said first section and said second section.

In fact, without the effect of the second section, the light-wave propagating through the first (gain) section typically does not experience enough phase change so as to reach the mode locking frequency variation range which is typically required by the customer (frequency variation provided is typically only about 80MHz as compared to several GHz as typically is required by the customer). Therefore, using said second (passive) section with sufficient current controlled index variation and with sufficient geometric length one may provide sufficient phase change for the light-wave propagating through the laser cavity, so that the GHz-range mode locking frequency variation may be achieved. According to some specific embodiments, the first section has a first length and the second section has a second length wherein said phase of the laser beam is further proportional to said first length and said second length.

Some embodiments of the invention feature a method for tuning a frequency of a mode locked laser diode, the laser diode comprising a first section made of an active material having a first refractive index and configured to provide gain for a laser emission of said diode and a second section made of a strained passive material having a second refractive index, the method comprising:

- propagating light-waves through said second section and said first section said light-waves having a phase,
- injecting a current to said second section thereby causing a change in said second refractive index of the second section such that said change in said refractive index causes a change in the phase of said light-waves, thereby varying the free spectral range of the laser beam.

According to some specific embodiments, said mode locked laser diode is a Fabry-Perot laser diode.

According to some specific embodiments, said mode locked laser diode is a monolithic mode locked laser diode.

According to some specific embodiments, said active material of the first section is preferably of quantum dashes or quantum dots and the passive material of the second section is preferably a transparent strained semiconductor material.

The advantage of the active material being of quantum dashes or quantum dots, is that the mode locked laser emission spectrum may become substantially flat and may present an equalized power frequency comb. Likewise the advantage of the passive material being preferably a transparent strained semiconductor material is that it may allow for reaching variations in the refractive index due to current injection which are substantially sufficient to fulfill the frequency tuning requirement, or the frequency comb spacing range requirement as required by the customer.

These and further features and advantages of the present invention are described in more detail, for the purpose of illustration and not limitation, in the following description as well as in the claims with the aid of the accompanying drawings.

BRIEF DESCRIPTION OF THE DRAWINGS

Figure 1, already discussed, is an exemplary graph representation of a relationship between frequency precision obtainable for a laser diode as a function of the desired frequency used in the laser cavity in a conventional device. Figure 2 is an exemplary cross-sectional representation of a structure of a mode locked laser diode according to some embodiments.

DETAILED DESCRIPTION

According to embodiments of the present invention, a mode locked laser diode (MLLD) is provided with a tuning section configured to tune the active section of the laser diode as will be described in further detail below with reference to figure 2.

Figure 2 shows an exemplary cross-sectional representation of a structure of an MLLD 1 according to some embodiments in which the MLLD 1 comprises a first section 11 made of an active material. The first section 11 is preferably made of Q1.55 InGaAsP bulk material where the parameter Q1.55 represents a quaternary InGaAsP material with a photoluminescence wavelength of 1.55μ as is known in the related art. The first section 11 is configured to provide optical gain for the light to be emitted by said laser diode. Herein, the first region 11 may also be referred to as the gain section or active section. A biasing terminal 12, for example an electrode, is used in order to provide a bias current to the active section 11 thereby enabling the power gain for the emission of a laser beam.

One preferred choice for the first section is the use of quantum dot or quantum dash material. In such a case, one may replace the bulk Q1.55 active material used conventionally in the active section by such quantum dot or quantum dash material, which has the capability of giving substantially flat optical spectral combs for bias currents above the lasing threshold.

The MLLD 1 further comprises a second section 13 made of a strained passive material. The strained passive material is preferably chosen from among materials having an optical refractive group index capable of varying relatively quickly with the injected current. In the context of the present description, the term "quickly" may refer to high dispersion properties of the material with respect to the injected current (namely the relationship dn/dl in such materials is typically higher than other materials typically used, such property may be obtained by using 0.1% strained Q1.45 bulk material.

The active section 11 and the passive section 13 are preferably both provided on a substrate 15 made of InP material.

The second section 13 may preferably be made of Q1.45 InGaAsP strained bulk material. However other strained passive materials which have an optical refractive group index capable of varying relatively quickly depending on the injected current may likewise be used. Such materials may include photonic crystals or other meta-materials. Herein, the second section may also be referred to as the tuning section or the passive section.

Those skilled in the related art will realize that the refractive index n is typically related to the velocity of light c in vacuum and the phase velocity v by the relationship : $v = c/n$; whereas the group index is defined by the group velocity (also called signal speed, or the speed of the envelop of an electromagnetic wave) by the following relation : $n_g = c/v_g$.

Furthermore, the relation between the refractive index n and the group index $n_g$ may be expressed as follows :

$n_g = n [ 1 — (\lambda/n) (dn/d\lambda)]$, where $\lambda$ is the wavelength of the lightwave. Therefore a change in the refractive index, may cause a change in the group index within a material.

The second section 13 is configured to tune a frequency of said laser emission in response to a current injected to said second section 13. The frequency tuning is performed due to the fact that the refractive index, and therefore the group index, of the passive section is changeable in response to a current injected into the second section. This property gives the second section the capability of being used for controlling the total optical length of the laser cavity.

It is to be noted that a refractive index change in a waveguide may result in phase change of any light-wave propagating through said waveguide. However inside a laser cavity, and more particularly inside a fabry-Perot laser cavity, the total phase of the lasing modes is typically some fixed numbers, which are an integer times $2\pi$ (thus causing a constructive phase relationship leading to the lasing modes). However, a change of the refractive index typically results in the change of the optical length. In the case of the present embodiments, the overall optical length nL of the laser cavity (n being the effective refractive index and L being the physical length of the cavity) may be defined by the relationship:

$$nL = (n_p L_p + n_a L_a)$$

where $n_p$ and Lp are respectively the refractive index and the length of the passive section or tuning section 13, whereas $n_a$ and $L_a$ are respectively the refractive index and the length of the active or gain section.

Thus the change in the optical length may cause a change in the lasing modes (or wavelengths) whereas the overall phase relationship between the lasing modes is kept fixed.

The above is done by applying a bias current to a second terminal 14, for example an electrode, which corresponds to the tuning section 13 as shown in figure 2. As the current injected in the device 1 through the terminal 14 varies, such variation causes a change in the refractive index of the passive material in the tuning section 13 which in turn causes a phase change in the light travelling in the MLLD structure 1.

In this manner by causing a change in the overall optical length of the laser cavity a change in frequency is obtained thereby allowing for tuning the frequency of the laser emission to the desired frequency. Preferably such change in the overall optical length is significant so as to reach significant changes in the frequency ranges to reach such ranges as required by a customer.

In the exemplary device of figure 2, a laser beam is considered to propagate through the second section 13 then through the first section 11 before it is emitted from the MLLD. Considering that the laser beam is emitted from the MMLD 1 with a phase change θ after propagation through the second and the first sections 13 and 11, said phase change θ may be expressed in terms of the indices of refraction in the following manner:

$$\theta = (2\pi / \lambda) (n_p L_p + n_a L_a) \qquad (1)$$

where $n_p$ and Lp are respectively the refractive index and the length of the passive section or tuning section 13, whereas $n_a$ and $L_a$ are respectively the refractive index and the length of the active or gain section. As it may be seen from the above relationship, a variation in $n_p$ may cause a variation in θ.

The phase changes due to a round-trip propagation of the light-waves through the laser cavity of a given optical length, therefore a change of the optical length will result in the phase change variation. However the lasing conditions typically require that the phase is kept at a value equal or about an integer multiple of 2π, so the lasing wavelengths are re-adjusted to the changed optical length of the cavity, resulting in a new FSR and thereby providing a new mode locked frequency.

Therefore a control in the injected current in the tuning section 13 allows for controlling the FSR of the laser spectrum emitted from the MLLD 1.

By way of an illustrative, and non-limiting example, a MLLD is considered comprising a gain section having a length of about 233μm, a tuning section with a length of about 834μm, an active material group index of 3.61 in the gain section, a passive material group index of about 3.49 in the tuning section and a current dispersion parameter Dn/dJ = 0.43μm³/mA where Dn and dJ represent the refractive index variation and the current density variation respectively. Calculation may show that these values could correspond to a 40GHz FSR laser, giving a typical tuning range in the order of a few GHz (instead of a few tens of MHz as is typically the case with the conventional devices). Such calculations may be based on the following criteria.

The above relationship (1) may be expressed in terms of frequency of a mode locked laser linking the mode locking frequency, $f_{ML}$, and the laser structure as follows :

$$f_{ML} = c / [2(n_p L_p + n_a L_a)]$$

As already mentioned above, it is desired to manufacture such lasers with an acceptable tolerance of the cleaving precision. Denoting the precision of the length of laser active section as $\Delta L_a$ and that of the passive section as $\Delta L_p$: the following relationship may be obtained:

$$\Delta f_{ML}/f_{ML} = (n_p\Delta L_p + n_a\Delta L_a)/( n_p L_p + n_a L_a).$$

A desired value for the above ration may be in the order of 5 parts in 1000 : 0.5%, which may lead to 200MHz for a 40GHz mode locked frequency. Using the current frequency control techniques (heating and carrier injection via current variation), typically a maximum of 80MHz may be achievable, thus showing the difficulty in reaching the 200MHz discrepancy using to known technologies. Thanks to the solution provided herein the above desired tolerance may be reached. For example by selecting a material for the tuning section exhibiting a high electrical dispersion : $dn_p/dJ_p$ = -0.43μm³/mA, where J is current density, the tuning of the frequency may follow the relationship bellow :

$$\Delta f_{ML} = 2 f_{ML}^2 (dn_p/dJ_p) I_p / (c\, w\, e)$$

where c is the velocity of light in vacuum, w and e are the width and the thickness of the tuning section waveguide respectively. In an exemplary implementation values of w=550nm and e = 420nm may be chosen, due to which the tuning section may have a desirably high mode confinement factor. Using such values, $\Delta f_{ML}$ may reach GHz ranges, for mode locked frequency of about $f_{ML}$= 40GHz.

In the design of such laser diodes it is preferable that the laser strip width w and thickness e be also taken into account, in addition to the length, because of the consideration based on the current density J as described above. However, for the sake of design convenience instead of the current density J, the bias current I may be used as in practice it may become more relevant for a designer to deal with bias currents.

In order to avoid that the maximum group index variation and the tuning current do not exceed reasonable values (due to material limitations), then the length of the tuning section may be determined following the relationship:

$$L_p \sim I_p (dn_p/dJ_p) / ( e w \Delta n_{pMax}).$$ For example a length Lp of 834$\mu$m, with Ip at about 90mA and An$_{pMax}$ of about 0.2.

Preferred materials for the active section may be Q1.55 InGaAsP, quantum dot or quantum dash, materials, the latter two being still more preferred. Preferred material for the tuning section may be Q1.45 InGaAsP strained bulk material showing typical parameters as listed for the example above.

Therefore, according to the embodiments of the present invention, a MLLD may be obtained with a tuning range for the laser of the order of GHz (for example about 1.7GHz at about 150mA current bias) which shows significant improvement as compared to the typical 40MHz tuning range for a single section MLLD as conventionally known, where only the active section bias current and the laser temperature are typically used for tuning.

It is also to be noted that in the case of the device of the present invention, the temperature of the laser may also have an effect on the tuning capabilities of the device. However, under comparable circumstances, the tuning range provided by the solution proposed herein is significantly better than that of conventional solutions.

In this manner, the frequency tuning range of the MLLD may be defined in accordance with the requirements established by the customer.

The MLLD according to the embodiments of the invention may be manufactured using known technologies such as for example butt coupling, or selective growth, or the like.

It is to be noted that the list of structures corresponding to the claimed means is not exhaustive and that one skilled in the art understands that equivalent structures can be substituted for the recited structure without departing from the scope of the invention.

## Claims

1. A frequency tunable mode locked laser diode comprising a first section made of an active material having a first refractive index and configured to provide gain for a laser emission of said diode and a second section made of a strained passive material having a second refractive index, said laser diode being configured to generate a laser beam by means of propagation of light-waves through said second section and said first section, said light-waves having a respective phase, wherein said second refractive index of the second section is changeable in response to a current injected to said second section such that a change in said refractive index causes a change in the phase of said light-waves, thereby varying the free spectral range of the laser beam.

2. The laser diode of claim 1 wherein said change in said refractive index causes a change in an optical length of a laser cavity comprising said first section and said second section.

3. The laser diode of claim 1 or claim 2 wherein the first section has a first length and the second section has a second length wherein said phase of the laser beam is further proportional to said first length and said second length.

4. The laser diode of any one of the preceding claims wherein said mode locked laser diode is a Fabry-Perot laser diode.

5. The laser diode of any one of the preceding claims wherein said mode locked laser diode is a monolithic mode locked laser diode.

6. The laser diode of any one of the preceding claims wherein said active material of the first section is preferably of quantum dashes or quantum dots and the passive material of the second section is preferably a transparent strained semiconductor material.

7. A method for tuning a frequency of a mode locked laser diode, the laser diode comprising a first section made of an active material having a first refractive index and configured to provide gain for a laser emission of said diode and a second section made of a strained passive material having a second refractive index, the method comprising:

    - propagating light-waves through said second section and said first section said light-waves having a phase,

- injecting a current to said second section thereby causing a change in said second refractive index of the second section such that said change in said refractive index causes a change in the phase of said light-waves, thereby varying the free spectral range of the laser beam.

14 12

13 11

15

1

FIG_2

FIG_1

FIG_1

Europäisches
Patentamt

European
Patent Office

Office européen
des brevets

# EUROPEAN SEARCH REPORT

**Application Number**

EP 10 30 6311

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/137694 A1 (PARK KYUNG HYUN [KR] ET AL PARK KYUNG HYUN [KR] ET AL) 12 June 2008 (2008-06-12) | 1,7 | INV. H01S5/065 H01S5/0625 |
| Y | * paragraphs [0003], [0007], [0008], [0012], [0021], [0022], [0035] - [0038], [0045], [0004], [0050], [0059], [0061], [0066]; claims 1,4,5; figure 1 * | 2-6 | ADD. H01S5/34 |
| Y | RONALD KAISER ET AL: "Monolithic 40-GHz Mode-Locked MQW DBR Lasers for High-Speed Optical Communication Systems", IEEE JOURNAL OF SELECTED TOPICS IN QUANTUM ELECTRONICS, IEEE SERVICE CENTER, PISCATAWAY, NJ, US, vol. 13, no. 1, 1 January 2007 (2007-01-01), pages 125-135, XP011163495, ISSN: 1077-260X, DOI: DOI:10.1109/JSTQE.2006.885330 * paragraphs [IV.A], [ IV.D]; figures 2,3 * | 1,5,7 | |
| Y | LEAF A JIANG ET AL: "Semiconductor mode-locked lasers as pulse sources for high bit rate data transmission", JOURNAL OF OPTICAL AND FIBER COMMUNICATIONS REPORTS, SPRINGER-VERLAG, NE, vol. 2, no. 1, 1 March 2005 (2005-03-01), pages 1-31, XP019368502, ISSN: 1619-8638 * paragraph [03.2]; figure 3 * | 1,7 | **TECHNICAL FIELDS SEARCHED (IPC)** H01S |
| Y | US 2008/279230 A1 (DAGENAIS MARIO [US]) 13 November 2008 (2008-11-13) * paragraphs [0003], [0021]; figures 1,2 * | 2 | |

-/--

The present search report has been drawn up for all claims

| Place of search | Date of completion of the search | Examiner |
|---|---|---|
| Munich | 25 March 2011 | Gnugesser, Hermann |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

  .......................................................................

& : member of the same patent family, corresponding
    document

EPO FORM 1503 03.82 (P04C01)

**EUROPEAN SEARCH REPORT**

Application Number

EP 10 30 6311

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | AKROUT A ET AL: "Low phase noise all-optical oscillator using quantum dash modelocked laser", THE INSTITUTION OF ENGINEERING AND TECHNOLOGY. JOURNAL,, vol. 46, no. 1, 7 January 2010 (2010-01-07), pages 73-74, XP006034464, ISSN: 1350-911X, DOI: DOI:10.1049/EL:20102886 * the whole document * | 3-6 | |
| A | KAISER R ET AL: "Repetition rate and wavelength tuning of monolithic 40 GHz mode-locked lasers based on InP", 2003 INTERNATIONAL CONFERENCE INDIUM PHOSPHIDE AND RELATED MATERIALS. CONFERENCE PROCEEDINGS. (IPRM). SANTA BARBARA, CA, MAY 12 - 16, 2003; [INTERNATIONAL CONFERENCE ON INDIUM PHOSPHIDE AND RELATED MATERIALS], NEW YORK, NY : IEEE, US, 12 May 2003 (2003-05-12), pages 255-258, XP010746836, DOI: DOI:10.1109/ICIPRM.2003.1205363 ISBN: 978-0-7803-7704-2 * the whole document * | 1,7 | |
| A | SHIN ARAHIRA ET AL: "Repetition-Frequency Tuning of Monolithic Passively Mode-Locked Semiconductor Lasers with Integrated Extended Cavities", IEEE JOURNAL OF QUANTUM ELECTRONICS, IEEE SERVICE CENTER, PISCATAWAY, NJ, USA, vol. 33, no. 2, 1 February 1997 (1997-02-01), XP011051553, ISSN: 0018-9197 * pages 255-258; figure 1 * | 1,7 | TECHNICAL FIELDS SEARCHED (IPC) |

The present search report has been drawn up for all claims

| Place of search | Date of completion of the search | Examiner |
|---|---|---|
| Munich | 25 March 2011 | Gnugesser, Hermann |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 30 6311

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2011

| Patent document cited in search report | | Publication date | Patent family member(s) | Publication date |
|---|---|---|---|---|
| US 2008137694 | A1 | 12-06-2008 | NONE | |
| US 2008279230 | A1 | 13-11-2008 | NONE | |

EPO FORM P0459

For more details about this annex : see Official Journal of the European Patent Office, No. 12/82